Europäisches Patentamt

European Patent Office

Office européen des brevets

(19)

(11) Publication number: **0 463 568 A2**

# EUROPEAN PATENT APPLICATION

(12)

(21) Application number: **91110159.0**

(22) Date of filing: **20.06.91**

(51) Int. Cl.⁵: **H01L 39/14**

(30) Priority: **22.06.90 JP 164549/90**
       **05.02.91 JP 35221/91**

(43) Date of publication of application:
**02.01.92 Bulletin 92/01**

(84) Designated Contracting States:
**DE FR GB IT**

(71) Applicant: **THE FURUKAWA ELECTRIC CO., LTD.**
**6-1, 2-chome, Marunouchi Chiyoda-ku Tokyo(JP)**

(72) Inventor: **Susai, Kyo-ta, c/o THE FURUKAWA ELEC. CO., LTD.**
**6-1, 2-chome, Marunouchi, Chiyoda-ku Tokyo(JP)**
Inventor: **Ishikawa, Minoru, c/o THE**

**FURUKAWA ELEC. CO., LTD.**
**6-1, 2-chome, Marunouchi, Chiyoda-ku Tokyo(JP)**
Inventor: **Ogawa, Kinya, c/o THE FURUKAWA ELEC. CO., LTD.**
**6-1, 2-chome, Marunouchi, Chiyoda-ku Tokyo(JP)**
Inventor: **Suzuki, Takuya, c/o THE FURUKAWA ELEC. CO., LTD.**
**6-1, 2-chome, Marunouchi, Chiyoda-ku Tokyo(JP)**

(74) Representative: **Hansen, Bernd, Dr. Dipl.-Chem. et al**
**Hoffmann, Eitle & Partner Patent- und Rechtsanwälte Arabellastrasse 4 Postfach 81 04 20**
**W-8000 München 81(DE)**

(54) Manufacturing method of copper stabilized multifilamentary Nb-Ti alloy superconducting wire.

(57) A method to decrease breakage of Nb-Ti filaments in the extension process of a multifilament billet and reduce the diameter of a number of Nb-Ti filaments to less than 30 $\mu$m, and mass-produce copper stabilized multifilamentary Nb-Ti alloy superconducting wire with excellent superconducting characteristics including critical current density is disclosed. The manufacturing method of copper stabilized multifilamentary Nb-Ti alloy superconducting wire comprises a process to fabricate superconducting monofilament wire (2) having a circular cross section and comprising Nb-Ti alloy filament in the copper matrix, a process to assemble a multifilament billet by packing a number of the superconducting monofilament wires (2) in a copper tube (1), thus forming a superconducting monofilament wires packed layer (3), arranging one or more layer of copper wires (4) between the superconducting monofilament wires packed layer (3) and the inner surface of the copper tube (1), a process to closed-pack the multifilament billet, and then extruder and draw the billet.

F I G. I

EP 0 463 568 A2

The present invention relates to a manufacturing method of copper stabilized multifilamentary Nb-Ti alloy superconducting wire used in superconducting power generation, MRI, and particle accelerators, and more specifically a manufacturing method of copper stabilized multifilamentary Nb-Ti alloy superconducting wire, with the improved assembly process of multifilament billet.

Recently, calls for developing longer-size copper stabilized multifilamentary Nb-Ti alloy superconducting wires with a extra fine multifilamentary construction in which about 2000 - 8000 extra fine Nb-Ti alloy filaments of 30 $\mu$m or smaller in diameter are embedded to improve superconductivity and with the least number of connections which cause attenuation of permanent current have been increased.

Conventionally, copper stabilized multifilamentary Nb-Ti alloy superconducting wires are produced by the methods described as follows. First of all, Nb-Ti alloy ingot is cast by the arc melting method and the like. Then, the Nb-Ti alloy ingot is extruded or rolled to be round bar. The round bar packed into a copper tube undergo extrusion and wire drawing process to make superconducting monofilament wire having round cross section. A number of superconducting monofilament wires produced in this way are aligned and cut to a specified length. The number of superconducting monofilament wires cut to a specified length are banded and packed into another copper tube having a larger diameter than that of the previous one to assemble a multifilament billet. In such event, a copper core is situated at the center of the copper tube as required, then the number of superconducting monofilament wires are packed between the inner surface of the copper tube and the copper core to be assembled a multifilament billet. Then, the multifilament billet undergoes the close-packing process, and extension work including hot extrusion and drawing takes place to produce copper stabilized extra fine multifilamentary Nb-Ti alloy superconducting wire of a specified size with a large number of Nb-Ti alloy filaments embedded.

When the number of Nb-Ti alloy filaments embedded in the copper matrix are further refined and increased, a method to extend after the number of the above-mentioned superconducting wire are packed in the copper tube is employed.

In the above-mentioned superconducting wire manufacturing method, the cross section of the number of superconducting monofilament wires in the copper tube are formed into a hexagon by closed-packing such as tapping and hot isostatic pressing (HIP) before hot extrusion. This closed-packing increases the packing density of the superconducting monofilament wires in the copper tube. The closed-packing by tapping is carried out by moving the multifilament billet while rotating between a pair of split molds whose opposite surface is semicircular as well as bringing each of the split molds closer or away each other to tap the multifilament billet. Closed-packing by HIP is carried out by placing a multifilament billet whose both end surfaces are sealed with a copper plate in the pressure container, heating the pressure container to, for instance, 500 - 800$^\circ$C to expand gas in the pressure container, and thereby pressurizing (1000 - 1500 atmosphere) the multifilament billet.

However, in closed-packing the multifilament billet, it is difficult to form the cross section of each superconducting monofilament wire near the inner surface of the copper tube into a hexagon, which becomes a rectangle. The cross section of each superconducting monofilament wire situated on the circumferential surface of a copper core is also difficult to be formed into a hexagon during the closed-packing when the copper core is arranged at the center of the copper tube and becomes a rectangle. Repeating drawing working in multiple times until the diameter of the Nb-Ti alloy filaments inside is reduced to 30 $\mu$m or smaller after hot extrusion working, the superconducting monofilament wires located in the vicinity of the inner surface of the copper tube (in the vicinity of the circumferential surface of the copper core when a copper core is arranged) causes abnormal deformation, resulting in frequent filaments breakage. As a result, there is a problem that superconducting wire with desired superconducting characteristics (e.g. critical current density: Jc) cannot be produced.

As another method to manufacture the superconducting wire, to fabricate superconducting monofilament wires having a hexagonal cross section beforehand, then pack the number of superconducting monofilament wires of the aforementioned form into a copper tube to fabricate a multifilament billet, and closed-pack, hot extrude, and draw the multifilament billet is well known. However, even in this manufacturing method, the superconducting monofilament wires located in the vicinity of the inner surface of the copper tube (in the vicinity of the circumferential surface of the copper core when a copper core in arranged) cannot maintain a hexagon cross section in the closed-packing process and produces a rectangular cross section. As a result, as described before, superconducting monofilament wires located in the vicinity of the copper tube breaks during drawing, impairing superconducting characteristics and degrading the reliability.

The objective of this invention is to provide a method to decrease breakage of superconducting monofilament wires in the extension process of multifilament billet and reduce the diameter of the number of Nb-Ti alloy filaments to less than 30 $\mu$m, and mass-produce copper stabilized multifilamentary Nb-Ti alloy superconducting wire with excellent superconducting characteristics including critical current density.

According to the present invention, a manufacturing method of copper stabilized multifilamentary Nb-Ti alloy superconducting wire comprises,

a process to fabricate superconducting monofilament wire having a circular cross section and comprising Nb-Ti alloy filament in a copper matrix;

a process to assemble a multifilament billet by packing a number of the superconducting monofilament wires in a copper tube, thus forming a superconducting monofilament wires packed layer, arranging one or more layers of copper wires between the superconducting monofilament wires packed layer and the inner surface of the copper tube; and

a process to closed-pack the multifilament billet, and then extrude and draw the billet.

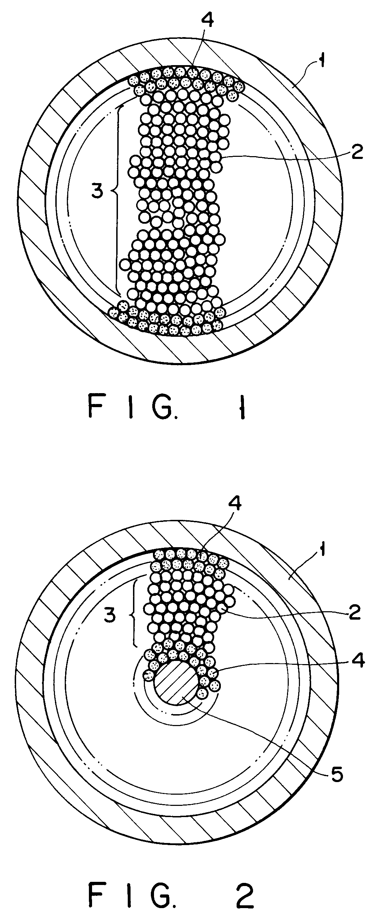

One condition of the multifilament billet is shown in Fig. 1, where the number of copper wire layers is two. Fig. 1 is a cross-sectional view of the multifilament billet. In the copper tube 1, a superconducting monofilament wires packed layer 3 formed by densely packing a number of superconducting monofilament wires 2 each having circular cross section is arranged. Copper wires 4 each having a circular cross section are densely arranged in two layers between the inner surface of the copper tube 1 and the superconducting monofilament wires packed layer 3.

According to the present invention, a manufacturing method of copper stabilized multifilamentary Nb-Ti alloy superconducting wire comprises,

a process to fabricate superconducting monofilament wire having a circular cross section and comprising Nb-Ti alloy filament in a copper matrix;

a process to assemble a multifilament billet by packing a number of the superconducting monofilament wires in a copper tube arranged a copper core at the center, thus forming a superconducting monofilament wires packed layer, arranging one or more layers of copper wires between the superconducting monofilament wires packed layer and the inner surface of the copper tube and between the packed layer and the copper core, respectively; and

a process to closed-pack the multifilament billet, and then extrude and draw the billet.

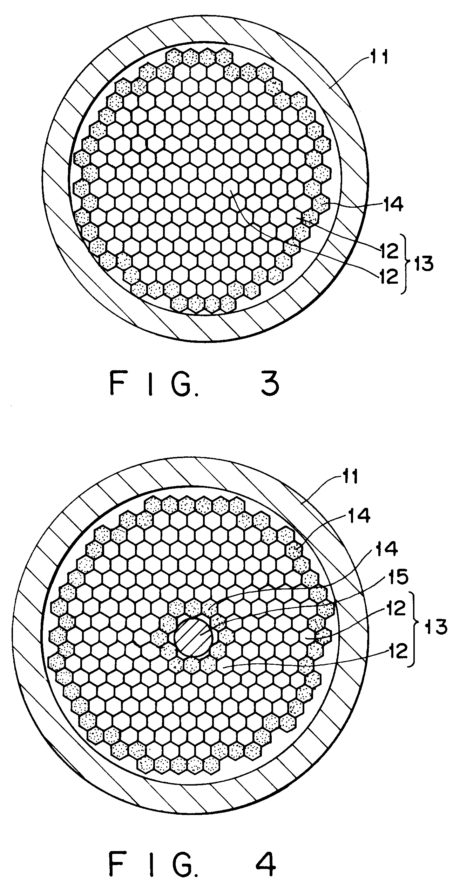

One condition of the multifilament billet (the number of copper wire layer is two) is shown in Fig. 2. Fig. 2 is a cross-sectional view of the multifilament billet. In a copper tube 1 having a copper core 5 arranged at the center, a superconducting monofilament wires packed layer 3 formed by densely packing a number of superconducting monofilament wires 2 each having a circular cross section is arranged. Copper wires 4 each having a circular cross section are densely arranged in two layers between the inner surface of the copper tube 1 and the superconducting monofilament wires packed layer 3 and between the copper core 5 and the packed layer 3, respectively.

In the preceding methods of the present invention, the superconducting monofilament wire having a circular cross section is fabricated by the regular method. For example, Nb-Ti alloy ingot is cast by the arc melting method and the like and the Nb-Ti alloy ingot is made into a round bar by extrusion and rolling, then the round bar is inserted in the copper tube, and extruded and drawn to make the superconducting monofilament wire.

Each copper wire in the preceding methods of the present invention works as a stabilizing material same as the copper tube and copper core. Consequently, wall thickness of the copper tube can be reduced in accordance with how much the copper wires occupies. The diameter of the copper core can be reduced in accordance with how much the copper wires occupies.

Each copper wire in the preceding methods of the present invention may have the cross section in a form of circle, hexagon, octagon, and other polygon. When one or more layers of copper wires are formed using copper wires having such forms, in general, copper wires of the same form are used. However, it is allowed to form one or more layers of copper wires by mixing copper wires having a circular cross section and a polygonal cross section. Specifically, when copper wires are installed in one layer, copper wires each having a circular cross section and that having a polygonal cross section may be mixed in the layer. When two or more layers are installed, the form may be varied according to layers by using copper wires having a circular cross section and that having a polygonal cross section.

In the preceding methods of the present invention, the area of the cross section of each copper wire is desirable to set the 0.01 - 10 times that of the superconducting monofilament wire. If the area of the cross section each copper wire is less than 0.01 times that of the superconducting monofilament wire, the operation to pack copper wires into the copper tube becomes complicated. In addition, when the copper wires are installed in one layer, it may be difficult to let the copper wires bear deformation generated near the inner surface of the copper tube or near the inner surface of the copper tube and near the circumferential surface of the copper core during the aforementioned closed-packing process. On the other hand, when the area of the cross section each copper wire exceeds 10 times that of the superconducting

3

EP 0 463 568 A2

monofilament wire, the stabilizing material portion of superconducting monofilament wire increases, possibly lowering the density of Nb-Ti alloy filaments per cross sectional area. In such event, it can be possible to reduce the wall thickness of the copper tube in accordance with the occupancy ratio of the copper wires or reduce the diameter of the copper core in accordance with the occupancy ratio of the copper wires to counteract the lowered density of filaments. However, if the number of layers of copper wires are increased, it might become impossible to counteract the situation only by reducing the wall thickness of the copper tube or the diameter of the copper core. The more desirable the area of the cross section of each copper wire is 0.5 - 5 times that of the superconducting monofilament wire.

The more desirable number of layers of copper wires in the preceding methods of the present invention is 2 - 6 layers. However, when the number of layers of copper wires exceeds 6 layers, not only the operation to suppress generation of abnormal forms of the superconducting monofilament wire is saturated but also the density of Nb-Ti alloy filaments which account for the total cross sectional area of fabricated superconducting wire may lower.

The closed-packing in the preceding methods of the present invention is carried out by, for example, tapping and hot isostatic pressing (HIP).

For the extension working in the preceding methods of the present invention, for example, drawing may be employed.

According to the present invention, to assemble a multifilament billet by packing a number of superconducting monofilament wires each having a circular cross section in a copper tube forming a superconducting monofilament wires packed layer, arranging one or more layers of copper wires between the packed layer and the inner surface of the copper tube. In the process to closed-pack the multifilament billet, one or more layers of the copper wires can be borne the deformation occurring in the vicinity of the inner surface of the copper tube. Consequently, it is possible to suppress abnormal deformation, such as rectangle, of superconducting monofilament wires (in particular, that located on the side near the inner surface of the copper tube). By allowing the multifilament billet after closed-packing to undergo extrusion and extension working, breakage arising from the portion where abnormal form of the superconducting monofilament wires are generated can be suppressed.

According to another method of the present invention, to assemble a multifilament billet by packing a number of superconducting monofilament wires each having a circular cross section in the copper tube having a copper core arranged at the center, thus forming a superconducting monofilament wires packed layer, arranging one or more layers of copper wires between the packed layer and the inner surface of the copper tube and between the packed layer and the copper core, respectively. In the process to closed-pack the multifilament billet, each one or more wire to bear layers of the copper wires can be borne the deformation occurring in the vicinity of the inner surface of the copper tube and the circumference of the copper core. Consequently, it is possible to suppress abnormal deformation, such as rectangle, of superconducting monofilament wires (in particular, that located on the side near the inner surface of the copper tube and the circumference of the copper core). By allowing the multifilament billet after closed-packing to undergo extrusion and extension working, breakage arising from the portion where abnormal form of the superconducting monofilament wires are generated can be suppressed.

Consequently, according to each method related to the present invention, reducing the breakage ratio of Nb-Ti alloy filaments during the extension process of the multifilament billet can produce copper stabilized multifilamentary Nb-Ti alloy superconducting wire at high yield. In addition, suppressing generation of the superconducting monofilament wires breakage during the extension process makes it possible to reduce the Nb-Ti alloy filaments diameter to 30 $\mu$m or smaller in the final extension process, and therefore, copper stabilized multifilamentary Nb-Ti alloy superconducting wire with excellent superconducting characteristics including critical current density can be produced.

In addition, according to the present invention, a manufacturing method of copper stabilized multifilamentary Nb-Ti alloy superconducting wire comprising,

a process to fabricate superconducting monofilament wire having a hexagonal cross section and comprising Nb-Ti alloy filament in the copper matrix;

a process to assemble a multifilament billet by packing a number of the superconducting monofilament wires in a copper tube, thus forming a superconducting monofilament wires packed layer, arranging one or more layers of copper wires between the superconducting filament wires packed layer and the inner surface of the copper tube (however, in case of one layer, each copper wire must have a hexagonal cross section, and in case of two or more layers, at least each copper wire of the first layer in contact with the packed layer must have a hexagonal cross section);

a process to closed-pack the multifilament billet, and then extrude and draw the billet.

One condition of the multifilament billet (the number of copper wire layer is two) is shown in Fig. 3. Fig.

4

3 is a cross-sectional view of the multifilament billet. In the copper tube 11, superconducting monofilament wires packed layer 13 formed by densely packing a number of superconducting monofilament wires 12 each having a hexagonal cross section is arranged. Copper wires 14 each having a hexagonal cross section are densely arranged in one layer between the inner surface of the copper tube 11 and the packed layer 13.

According the present invention,

a manufacturing method of copper stabilized multifilament Nb-Ti alloy superconducting wire comprising,

a process to fabricate superconducting monofilament wire having a hexagonal cross section and comprising Nb-Ti alloy filament in the copper matrix;

a process to assemble a multifilament billet by packing a number of the superconducting monofilament wires in a copper tube arranged a copper core at the center, thus forming a superconducting monofilament wires packed layer, arranging one or more layers of copper wires between the superconducting monofilament wires packed layer and the inner surface of the copper tube and between the packed layer and the copper core, respectively (however, in case of one layer, each copper wire must have a hexagonal cross section, and in case of two or more layers, at least each copper wire of the first layer in contact with the packed layer must have a hexagonal cross section);

a process to closed-pack the multifilament billet, and then extrude and draw the billet.

One condition of the multifilament billet (the number of copper wire layer is two) is shown in Fig. 4. Fig. 4. is a cross-sectional view of the multifilament billet. In the copper tube 11 having the copper core 15 arranged at the center, a superconducting monofilament wires packed layer 13 formed by densely packing a number of superconducting monofilament wires 12 each having a hexagonal cross section is arranged. Copper wires 14 each having a hexagonal cross section are densely arranged in two layers between the inner surface of the copper tube 11 and the superconducting wire packed layer 13 and between the copper core 15 and the packed layer 13, respectively.

In the preceding methods of the present invention, the superconducting monofilament wire having a hexagonal cross section is fabricated by the regular method. For example, Nb-Ti alloy ingot is cast by the arc melting method and the like and the Nb-Ti alloy ingot is made into a round bar by extrusion and rolling, then the round bar is inserted in the copper tube, and extruded and drawn to make the superconducting monofilament wire.

Each copper wire in the preceding methods of the present invention works as a stabilizing material same as the copper tube and the copper core. Consequently, wall thickness of the copper tube can be reduced in accordance with how much the copper wires occupies. The diameter of the copper core can be reduced in accordance with how much the copper wires occupies.

When each copper wire cross section is hexagonal in the preceding methods of the present invention, it is desirable to set the opposite side distance of the copper wire to 0.9 - 1 times that of the superconducting monofilament wire. This is due to the following reasons. If the opposite side distance of each copper wire deviates from the above range, it is become difficult to bring the copper wires arranged near the inner surface of the copper tube in close contact with the superconducting monofilament wires having a hexagonal cross section arranged inside the copper wires. Moreover, in case of arranging in the copper tube the copper core at the center, it is become difficult to bring the copper wires arranged near the circumferential surface of the copper core in closed contact with the superconducting monofilament wires having a hexagonal cross section arranged outside the copper wires. Consequently, it may become difficult to let the copper wires bear deformation generated near the inner surface of the copper tube or near the inner surface of the copper tube and near the circumferential surface of the copper core during the aforementioned closed-packing process. That is, if the copper wires arranged near the inner surface of the copper tube or arranged near circumferential surface of the copper core deforms, the superconducting monofilament wires may take abnormal form such as rectangle due to the clearance generated between the copper wires and the superconducting monofilament wires. The more desirable opposite side distance of each copper wire having a hexagonal cross section is 0.95 - 1 times that of the superconducting monofilament wire.

The desirable number of layers of the copper wires in the preceding methods of the present invention is 1 - 3 layers. However, when the number of layers of the copper wires exceeds three, not only the operation to suppress abnormal deformation of the superconducting monofilament wires is saturated but also there is a possibility to lower the density of Nb-Ti alloy filaments per cross sectional area of the fabricated superconducting wire.

If the number of layers of the copper wires in the preceding methods of the present invention is two or more, at least the copper wires having a hexagonal cross section should be used as the copper wires of the first layer in contact with the packed layer. However, for the copper wires other than the first layer, that

EP 0 463 568 A2

having a hexagonal cross section, octagonal cross section, or with a form with these polygons spitted into two may be used.

The closed-packing in the preceding methods of the present invention is carried out by, for example, tapping and hot isostatic pressing (HIP).

For the extension working in the preceding methods of the present invention, for example, drawing may be employed.

According to the present invention, to assemble a multifilament billet by packing a number of the superconducting monofilament wires each having a hexagonal cross section in a copper tube, thus forming a superconducting monofilament wires packed layer, arranging one or more layers of copper wires between the superconducting monofilament wires packed layer and the inner surface of the copper tube (however, in case of one layer, each copper wire must have a hexagonal cross section, and in case of two or more layers, at least each copper wire of the first layer in contact with the packed layer must have a hexagonal cross section). In the process to closed-pack the multifilament billet, one or more layers of the copper wires can be borne the deformation occurring in the vicinity of the inner surface of the copper tube. Consequently, it is possible to suppress abnormal deformation, such as rectangle, of superconducting monofilament wires (in particular, that located on the side near the inner surface of the copper tube). By allowing the multifilament billet after closed-packing to undergo extrusion and extension working, breakage arising from the portion where abnormal form of the superconducting monofilament wires are generated can be suppressed.

According to another method of the present invention, to assemble a multifilament billet by packing a number of the superconducting monofilament wires each having a hexagonal cross section in a copper tube arranged a copper core at the center, thus forming a superconducting monofilament wires packed layer, arranging one or more layers of copper wires between the superconducting monofilament wires packed layer and the inner surface of the copper tube and between the packed layer and the copper core, respectively (however, in case of one layer, each copper wire must have a hexagonal cross section, and in case of two or more layers, at least each copper wire of the first layer in contact with the packed layer must have a hexagonal cross section). In the process to closed-pack the multifilament billet, each one or more layers of the copper wires can be borne the deformation occurring in the vicinity of the inner surface of the copper tube and the circumference of the copper core. Consequently, it is possible to suppress abnormal deformation, such as rectangle, of superconducting monofilament wires (in particular, that located on the side near the inner surface of the copper tube). By allowing the multifilament billet after closed-packing to undergo extension working, breakage arising from the portion where abnormal form of the superconducting monofilament wires are generated can be suppressed.

Consequently, according to each method related to the present invention, reducing the breakage ratio of Nb-Ti filaments during the extension process of the multifilament billet can produce copper stabilized multifilamentary Nb-Ti alloy superconducting wire at high yield. In addition, suppressing generation of the superconducting monofilament wires breakage during the extension process makes it possible to reduce the Nb-Ti alloy filaments diameter to 30 $\mu$m or smaller in the final extension process, and therefore, copper stabilized multifilamentary Nb-Ti alloy superconducting wire with excellent superconducting characteristics including critical current density can be produced.

This invention can be more fully understood from the following detailed description when taken in conjunction with the accompanying drawings, in which:

Fig. 1 is a cross-sectional view showing one condition of a multifilament billet assembled by one method related to the present invention;

Fig. 2 is a cross-sectional view showing one condition of a multifilament billet assembled by the other method related to the present invention;

Fig. 3 is a cross-sectional view showing one condition of a multifilament billet assembled by another method related to the present invention; and

Fig. 4 is a cross-sectional view showing one condition of a multifilament billet assembled by still another method related to the present invention.

Referring now to the drawings, preferred embodiments according to the present invention will be described in detail hereinafter.

Embodiment 1 through 5

First of all, a Nb-Ti ingot of 150 mm in outside diameter was inserted in a copper tube of 200 mm in outside diameter and 155 mm in inside diameter, and was extruded to reduce the outside diameter to 22 mm, then cold extended and drawn to fabricate superconducting monofilament wire having a circular cross

6

section of 2.38 mm in outside diameter and comprising a Nb-46.5 wt%Ti alloy filament in the copper matrix.

Then, 7000 pieces of the superconducting monofilament wires were packed in a hollow copper billet (copper tube) of 260 mm in outside diameter and a superconducting monofilament wires packed layer was arranged in the hollow copper billet. At the same time, between the inner surface of the hollow copper billet and the packed layer, copper wires having a circular cross section of 2.38 mm in diameter were arranged in one, two, three, five, and six layers, respectively, and five types of multifilament billets having varying layers were assembled. The hollow copper billets having varying wall thickness according to the number of layers of copper wires arranged in the inside were assembled. That is, a hollow copper billet of 186 mm in inside diameter was used, when one layer of copper wires was arranged, that of 191 mm in inside diameter when two layers of copper wires were arranged, that of 195 mm in inside diameter when three layers of copper wires were arranged, that of 205 mm in inside diameter when five layers of copper wires were arranged, that of 209 mm in inside diameter when six layers of copper wires were arranged.

Next, each multifilament billet was compression molded by hot isostatic pressing (HIP) for close-packing, faced, then hot extruded to make a multifilament bars of 30 mm in outside diameter. Then, the multifilament bars were drawn to make five types of copper stabilized multifilamentary Nb-Ti alloy superconducting wires of 0.8 mm in outside diameter. The drawing was carried out after heat treatment during the process. The diameter of each Nb-Ti alloy filament embedded in superconducting wires fabricated in this manner is 6 $\mu$m. The ratio of the copper matrix to the Nb-Ti alloy filament (matrix/Nb-Ti filament) was 1.9.

Comparison 1

Copper stabilized multifilamentary Nb-Ti alloy superconducting wire was produced in the manner similar to Embodiment 1 except the use of multifilament billet assembled by packing 7000 pieces of superconducting monofilament wires into a hollow copper billet of 260 mm in outside diameter and 181 mm in inside diameter and arranging only a superconductor monofilament wires packed layer in the hollow copper billet.

For the superconducting wires manufactured by Embodiment 1 through 5 and Comparison 1, critical current density (Jc), n value, and filaments breakage ratio were measured.

The Jc was found from the value when the superconducting wire was energized by slowly increasing the current with the superconducting wire applied with 5% magnetic field in liquefied helium (4.2 K) and the resistance reached $10^{-11}$ $\Omega$cm.

The n value is defined by $V = aI^n$ where I (ampere) denotes the current energizing the superconducting wire and V (volt) denotes the voltage generated then, and indicates soundness of filament.

The wire breakage ratio of the filaments was found by immersing the superconducting wire in the nitric acid solution to dissolve and remove copper as matrix and exposing the embedded Nb-Ti alloy filaments, counting the number of broken filament.

The results are shown in Table 1.

## Table 1

| | No. of copper wires layer | Hallow copper billet | | JC A/mm$^2$ | n value | Filament breakage ratio % |
| | | Outside diameter mm | Inside diameter mm | | | |
|---|---|---|---|---|---|---|
| Embodiment 1 | 1 | 260 | 186 | 2950 | 50 | 7 |
| Embodiment 2 | 2 | " | 191 | 3000 | 60 | 5 |
| Embodiment 3 | 3 | " | 195 | 3050 | 70 | 2 |
| Embodiment 4 | 5 | " | 205 | 3055 | 70 | 2 |
| Embodiment 5 | 6 | " | 209 | 3055 | 70 | 2 |
| Comparison 1 | 0 | " | 181 | 2880 | 30 | 9 |

As clear from Table 1, the superconducting wires produced by Embodiment 1 through 5 of the present invention all exhibit high Jc values and n values, and sound filaments embedded in the copper matrix, and low filament breakage ratio.

In contrast, the superconducting wire produced by Comparison 1 has a high filament breakage ratio and low n value and Jc. The breakage of filaments of the superconducting wire is concentrated to the place corresponding to the vicinity of the inner surface of the hollow copper billet.

Embodiment 6

Superconducting monofilament wires packed layer was arranged in a hollow copper ballet by packing 7,000 pieces of the superconducting monofilament wires each having a circular cross section similar to that of Embodiment 1 in the hollow copper billet (copper tube) of 260 mm in outside diameter and 206 mm in the inside diameter with a copper core of 73 mm in outside diameter arranged at the center. At the same time, the copper wires each having a circular cross section of 2.38 mm in the outside diameter were arranged in two layers between the packed layer and the inner surfaced of the hallow copper billet and between the packed layer and the copper core, respectively, to assemble a multifilament billet. Then, this multifilament billet was allowed to undergo closed packing, facing, and hot extrusion similar to that of Embodiment 1 to make a multifilament bar of 30 mm in outside diameter, which was then extruded to make copper stabilized multifilament Nb-Ti alloy superconducting wire of 0.8 mm in outside diameter. The diameter of each Nb-Ti alloy filament embedded in the superconducting wire produced in this manner was 6 $\mu$m. The ratio of the copper matrix to the Nb-Ti alloy filament (matrix/Nb-Ti filament) was 1.9.

For the superconducting wire produced by Embodiment 6, the critical current density (Jc), n value, and filament breakage ratio were measured in the manner similar to that of Embodiment 1. The measurement results showed the Jc as high as 3050 A/mm$^2$ and the n value as high as 70, indicating the formation of sound filaments, and the wire breakage ratio was 2%.

Embodiments 7 through 9

First of all, a Nb-Ti alloy ingot of 150 mm in outside diameter was inserted in a copper tube of 200 mm in outside diameter and 155 mm in inside diameter, and was extruded to reduce the outside diameter to 22 mm, then cold extended and drawn, and finally drawn with a dice with a hexagonal hole to make superconducting monofilament wire having a hexagonal cross section of 2.27 mm in opposite side distance, which comprises Nb-47 wt%Ti alloy filament in the copper matrix.

Then, 7,000 pieces of the superconducting monofilament wires were packed in a hollow copper billet of 260 mm in outside diameter and the superconducting monofilament wires packed layer was arranged in the hollow copper billet. At the same time, the copper wires each having a hexagonal cross section of 2.27 mm in opposite side distance were arranged in a range of 1 - 3 layers between the inner surface of the hollow copper billet and the superconducting monofilament wires packed layer to assemble three types of multifilament billets with varying number of copper wire layers. The hollow copper billets used had wall thickness varied according to the number of layers of copper wires arranged on the inner surface. That is, a hollow billet of 186 mm in inside diameter was used when one layer of the copper wires was arranged, that of 191 mm in inside diameter when two layers of the copper wires were arranged and that of 195 mm in inside diameter when three layers of the copper wires were arranged.

Then, the multifilament billets were compression-formed by hot isostatic pressing (HIP) for closed packing, faced, and hot extruded to make multifilament bars of 30 mm in outside diameter. Then, they were drawn to make three types of copper stabilized multifilamentary Nb-Ti alloy superconducting wires of 0.8 mm in outside diameter. Heat treatment was also carried out during drawing. The diameter of each Nb-Ti alloy filament embedded in superconducting wires manufactured in this manner was 6 $\mu$m. The ratio of copper matrix to the Nb-Ti filament (matrix/Nb-Ti filament) was 1.9. Comparison 2

Copper stabilized multifilamentary Nb-Ti alloy superconducting wire was produced in the manner similar to Embodiment 7 except the use of multifilament billet assembled by packing 7000 pieces of superconducting monofilament wires into a hollow copper billet of 260 mm in outside diameter and 181 mm in inside diameter and arranging only the superconductor monofilament wires packed layer in the hollow copper billet.

For the superconducting wires manufactured by Embodiments 7 through 9 and Comparison 2, critical current density (Jc), n value, and filament breakage ratio were measured. The results are shown in Table 2.

The results are shown in Table 2.

Table 2

| | No. of copper wires layer | Hallow copper billet | | JC A/mm² | n value | Filament breakage ratio % |
| | | Outside diameter mm | Inside diameter mm | | | |
|---|---|---|---|---|---|---|
| Embodiment 7 | 1 | 260 | 186 | 3040 | 65 | 1 |
| Embodiment 8 | 2 | " | 191 | 3060 | 70 | 0 |
| Embodiment 9 | 3 | " | 195 | 3060 | 70 | 0 |
| Comparison 2 | 0 | " | 181 | 2940 | 40 | 8 |

As clear from Table 2, the superconducting wires produced by Embodiments 7 through 9 of the present invention all exhibit high Jc values and n values, and sound filaments embedded in the copper matrix, and low filament breakage ratio.

In contrast, the superconducting wire produced by Comparison 2 has a high filament breakage ratio and low n value and Jc. The breakage of filaments of the superconducting wire are concentrated to the place corresponding to the vicinity of the inner surface of the hollow copper billet.

Embodiment 10

7,000 pieces of the superconducting monofilament wires each having a hexagonal cross section similar to that of Embodiment 7 were packed in a hollow copper billet (copper tube) of 260 mm in outside diameter and 201 mm in inside diameter with a copper core of 77 mm in outside diameter arranged at the center and the superconducting monofilament wires packed layer was arranged in the hollow copper billet. At the same time, the copper wires each having a hexagonal cross section of 2.27 mm in opposite side distance were arranged in a range of one layer each between the inner surface of the hollow copper billet and the superconducting wire packed layer and between the packed layer and the copper core to assemble a multifilament billet. The multifilament billet was compression-formed by hot isostatic pressing (HIP) for closed packing, faced, and hot extruded in the manner similar to in Embodiment 7 to make a multifilament bar of 30 mm in outside diameter. Then, they were drawn to make copper stabilized multifilamentary Nb-Ti alloy superconducting wire of 0.8 mm in outside diameter in the manner similar to in Embodiment 7. Heat treatment was also carried out during drawing. The diameter of each Nb-Ti alloy filament embedded in superconducting wire manufactured in this manner was 6 $\mu$m. The ratio of copper matrix to the Nb-Ti filament (matrix/Nb-Ti filament) was 1.9.

For the superconducting wire produced by Embodiment 10, the critical current density (Jc), n value, and filament breakage ratio were measured in the manner similar to that of Embodiment 1. The measurement results showed the Jc as high as 3045 A/mm² and the n value as high as 65, indicating the formation of sound filaments, and the wire breakage ratio was 1%.

As described above, according to the present invention, it is possible to reduce breakage of Nb-Ti alloy filaments during the extrusion and extension process of the multifilament billet and to make the diameter of a number of Nb-Ti alloy filaments embedded in the copper matrix as fine as 30 $\mu$m or smaller, thereby providing a method to mass-produce copper stabilized multifilamentary Nb-Ti alloy superconducting wire with excellent superconducting characteristics including the critical current density and suited to superconducting power generation, MRI, and particle accelerators.

**Claims**

1. A manufacturing method of copper stabilized multifilamentary Nb-Ti alloy superconducting wire comprising,

a process to fabricate superconducting monofilament wire (2) having a circular cross section and comprising Nb-Ti alloy filament in the copper matrix;

a process to assemble a multifilament billet by packing a number of the superconducting monofilament wires (2) in a copper tube (1), thus forming a superconducting monofilament wires packed layer (3), arranging one or more layers of copper wires (4) between the superconducting monofilament wires packed layer (3) and the inner surface of the copper tube (1); and
a process to closed-pack the multifilament billet, and then extrude and draw the billet.

2. The method according to claim 1, characterized in that each copper wire (4) has a circular or polygonal cross section.

3. The method according to claim 1, characterized in that the area of the cross section of each copper wire (4) is 0.01 - 10 times that of the superconducting monofilament wire (2).

4. The method according to claim 1, characterized in that the copper wires (4) are arranged in two to six layers between the superconducting monofilament wires packed layer (3) and the inner surface of the copper tube (1).

5. The method according to claim 4, characterized in that the 2 - 6 layers of copper wires (4) consist of a layer of a copper wires each having a circular cross section and a layer of a copper wires each having a polygonal cross section.

6. The method according to claim 1, characterized in that the copper stabilized multifilamentary Nb-Ti alloy superconducting wire has a construction in which a number of Nb-Ti alloy filaments of 30 $\mu$m or smaller in thickness are embedded.

7. A manufacturing method of copper stabilized multifilamentary Nb-Ti alloy superconducting wire comprising,
a process to fabricate superconducting monofilament wire (2) having a circular cross section and comprising Nb-Ti alloy filament in the copper matrix;
a process to assemble a multifilament billet by packing a number of the superconducting monofilament wires (2) in a copper tube (1) arranged a copper core (5) at the center, thus forming a superconducting monofilament wires packed layer (3), arranging one or ore layers of copper wires (4) between the superconducting monofilament wires packed layer (3) and the inner surface of the copper tube (1) and between the packed layer (3) and the copper core (5), respectively; and
a process to closed-pack the multifilament billet, and then extrude and draw the billet.

8. The method according to claim 7, characterized in that each copper wire (4) has a circular or polygonal cross section.

9. The method according to claim 7, characterized in that the area of the cross section of each copper (4) is 0.01 - 10 times that to the superconducting monofilament wire (2).

10. The method according to claim 7, characterized in that the copper wires (4) are arranged in two to six layers between the superconducting monofilament wires packed layer (3) and the inner surface of the copper tube (1) and between the packed layer (3) and the copper core (5), respectively.

11. The method according to claim 10, characterized in that the 2 - 6 layers of copper wires (4) consist of a layer of a copper wires each having a circular cross section and a layer of a copper wires each having a polygonal cross section.

12. The method according to claim 7, characterized in that the copper stabilized multifilamentary Nb-Ti alloy superconducting wire has a construction in which a number of Nb-Ti alloy filaments of 30 $\mu$m or smaller in thickness are embedded.

13. A manufacturing method of copper stabilized multifilamentary Nb-Ti alloy superconducting wire comprising,
a process to fabricate superconducting monofilament wire (12) having a hexagonal cross section and comprising Nb-Ti alloy filament in the copper matrix;
a process to assemble a multifilament billet by packing a number of the superconducting monofilament wires (12) in a copper tube (11), thus forming a superconducting monofilament wires packed layer (13), arranging one or more layers of copper wires (14) between the superconducting monofilament wires packed layer (13) and the inner surface of the copper tube (11) (however, in case of one layer, each copper wire (14) must have a hexagonal cross section, and in case of two or more layers, at least each copper wire (14) of the first layer in contact with the packed layer (13) must have a hexagonal cross section); and

a process to closed-pack the multifilament billet, and then extrude and draw the billet.

14. The method according to claim 13, characterized in that each copper wire (14) having a hexagonal cross section is an opposite side distance 0.9 - 1 times that of the superconducting monofilament wire (12) having a hexagonal cross section.

15. The method according to claim 13, characterized in that the copper wires (14) are arranged in one to three layers between the superconducting monofilament wires packed layer (13) and the inner surface of the copper tube (11).

16. The method according to claim 13, characterized in that the copper stabilized multifilamentary Nb-Ti alloy superconducting wire has a construction in which a number of Nb-Ti alloy filaments of 30 $\mu$m or smaller in thickness are embedded.

17. A manufacturing method of copper stabilized multifilamentary Nb-Ti alloy superconducting wire comprising,

a process to fabricate superconducting monofilament wire (12) having a hexagonal cross section and comprising Nb-Ti alloy filament in the copper matrix;

a process to assemble a multifilament billet by packing a number of the superconducting monofilament wires (12) in a copper tube (11) arranged a copper core (15) at the center, thus forming a superconducting monofilament wires packed layer (13), arranging one or more layers of copper wires (14) between the superconducting monofilament wires packed layer (13) and the inner surface of the copper tube (11) and between the packed layer (13) and the copper core (15), respectively (however, in case of one layer, each copper wire (14) must have a hexagonal cross section, and in case of two or more layers, at least each copper wire (14) of the first layer in contact with the packed layer (13) must have a hexagonal cross section); and

a process to closed-pack the multifilament billet, and then extrude and draw the billet.

18. The method according to claim 17, characterized in that each copper wire (14) having a hexagonal cross section is an opposite side distance 0.9 - 1 times that of the superconducting monofilament wire (12) having a hexagonal cross section.

19. The method according to claim 17, characterized in that the copper wires (14) are arranged in one to three layers between the superconducting monofilament wires packed layer (13) and the inner surface of the copper tube (11) and between the packed layer (19) and the copper core (15), respectively.

20. The method according to claim 17, characterized in that the copper stabilized multifilamentary Nb-Ti alloy superconducting wire has a construction in which a number of Nb-Ti alloy filaments of 30 $\mu$m or smaller in thickness are embedded.

F I G. 1

F I G. 2

F I G. 3

F I G. 4